# EUROPEAN PATENT SPECIFICATION

(11) **EP 1 434 265 B1**
(45) Date of publication and mention of the grant of the patent: **09.09.2015**
(21) Application number: 03029282.5
(22) Date of filing: 22.12.2003
(51) Int. Cl.: H01L 23/373, H05K 1/09, H05K 1/03

(54) **Heat-conducting multilayer substrate and power module**
Wärme leitendes mehrschichtiges Substrat und Leistungshalbleitermodul
Substrat conducteur de chaleur multicouche et module de puissance

(30) Priority: 27.12.2002 JP 2002380401; 27.11.2003 JP 2003397839
(43) Date of publication of application: 30.06.2004
(73) Proprietor: Mitsubishi Materials Corporation, Tokyo (JP)
(72) Inventor: Nagatomo, Yoshiyuki, Naka-cho Naka-gun Ibaraki-ken (JP); Negishi, Takeshi, Omiya-ku Saitama-shi Saitama-ken (JP); Nagase, Toshiyuki, Naka-cho Naka-gun Ibaraki-ken (JP)
(74) Representative: Hoffmann Eitle

(56) References cited:
- EP-A- 0 874 399
- US-A1- 2002 125 505
- PATENT ABSTRACTS OF JAPAN vol. 015, no. 213 (E-1073), 30 May 1991 (1991-05-30) -& JP 03 060186 A (HITACHI CABLE LTD), 15 March 1991 (1991-03-15)
- PATENT ABSTRACTS OF JAPAN vol. 015, no. 213 (E-1073), 30 May 1991 (1991-05-30) -& JP 03 060192 A (HITACHI CABLE LTD), 15 March 1991 (1991-03-15)
- PATENT ABSTRACTS OF JAPAN vol. 014, no. 182 (E-0916), 12 April 1990 (1990-04-12) -& JP 02 032590 A (HITACHI CABLE LTD), 2 February 1990 (1990-02-02)
- PATENT ABSTRACTS OF JAPAN vol. 2002, no. 09, 4 September 2002 (2002-09-04) -& JP 2002 129313 A (NIKKO MATERIALS CO LTD), 9 May 2002 (2002-05-09)
- PATENT ABSTRACTS OF JAPAN vol. 014, no. 544 (C-0784), 4 December 1990 (1990-12-04) -& JP 02 232326 A (KOBE STEEL LTD), 14 September 1990 (1990-09-14)

## Description

### BACKGROUND OF THE INVENTION

### Field of the Invention

The present invention relates to a power module substrate used in a semiconductor device that controls large voltage and large current, and more particularly, to a power module equipped with a radiator that diffuses heat generated from a semiconductor chip.

### Description of Related Art

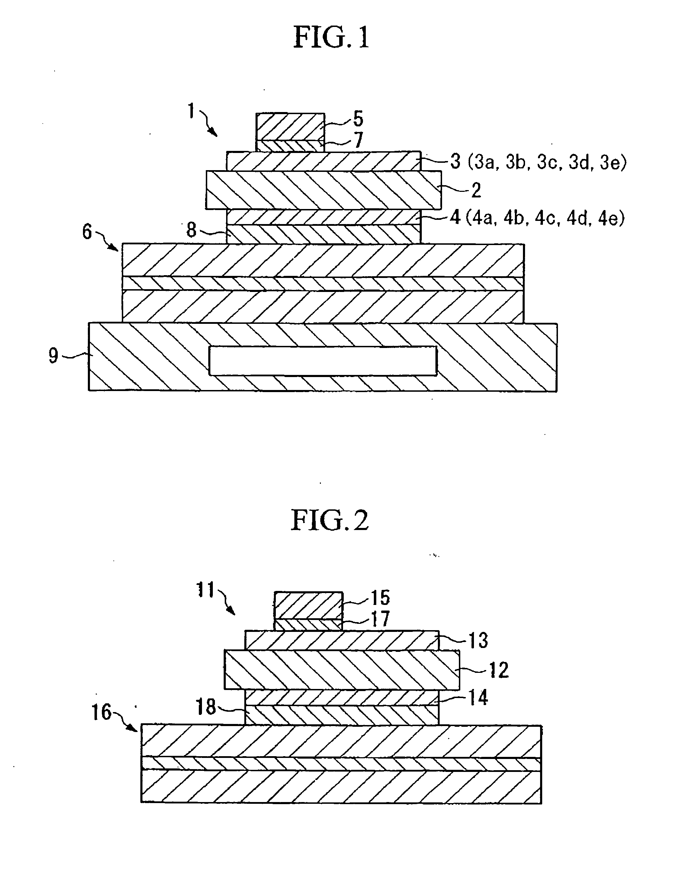

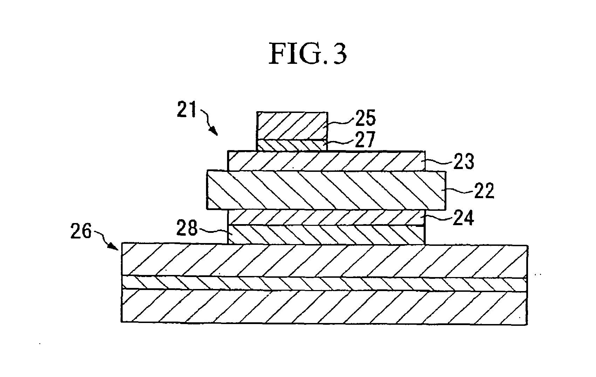

Known examples of this type of power module substrate of the prior art include a power module 11 as shown in FIG. 2, in which a circuitry layer 13 composed of Al or Cu is laminated on one side of an insulating substrate 12 made of AlN, a metal layer 14 made of Al or Cu is laminated on the other side, a semiconductor chip 15 is loaded onto circuitry layer 13 by means of solder 17, and a radiator 16 is joined to a metal layer 14 by solder 18 or brazing and so forth, and a power module as shown in FIG. 3, in which a circuitry layer 23 composed of 4N-Al (aluminum of at least 99.99% purity) is laminated onto one side of an insulating substrate 22 made of AlN, a metal layer 24 composed of 4N-Al is laminated onto the other side, a semiconductor chip 25 is loaded onto circuitry layer 23 by means of solder 27, and a radiator 26 is joined to metal layer 24 by solder 28, brazing and so forth. Various types of these power modules are provided (refer to, for example, Japanese Patent Application, First Publication No. 4-12554).

In the aforementioned power modules 11 and 21, radiators 16 and 26 are attached to, for example, a cooling sink section (not shown), and heat from semiconductor chips 15 and 25 that is transferred to radiators 16 and 26 is released to the outside through cooling water (or cooling air) inside the cooling sink.

However, in power modules 11 and 21 having a constitution like that described above, in the case of circuitry layers 13 and 23 and metal layers 14 and 24 being composed of Cu, when the substrate is subjected to repeated heat cycle of -40°C to 125°C, cracks form in solder 17 and 27 interposed between circuitry layers 13 and 23 and semiconductor chips 15 and 25 after about several tens to 100 cycles, and after about 500 cycles, circuitry layers 13 and 23 end up separating from insulating substrates 12 and 22. However, in the case of composing circuitry layers 13 and 23 and metal layers 14 and 24 with Al, cracks do not form in solder 17 and 27 interposed between circuitry layers 13 and 23 and semiconductor chips 15 and 25 until about 3000 cycles. This is because, in the case of subjecting to repeated heat cycle, in contrast to internal stress not accumulating in the case of composing circuitry layers 13 and 23 and metal layers 14 and 24 with Al, in the case of composing with Cu, internal stress accumulates. Thus, a constitution should be employed for which there is no accumulation of internal stress in order to extend a life of the substrates toward heat cycle.

On the other hand, since Cu is better than Al when a comparison is made of the thermal conductivities of Al and Cu, it is better to compose circuitry layers 13 and 23 and metal layers 14 and 24 with Cu due to its satisfactory thermal conductivity in order to allow heat from semiconductor chips 15 and 25 to be efficiently released by transferring to the side of radiators 16 and 26. However, since there is the problem of accumulation of internal stress as previously described in the case of using Cu, it was difficult to satisfy requirements for both a long life toward heat cycle and satisfactory thermal conductivity, and one of the two had to be sacrificed.

In consideration of the aforementioned problems of the prior art, an object of the present invention is to provide a power module substrate which, together with being able to extend the life toward heat cycle, is also capable of obtaining a satisfactory heat transfer rate to allow heat from a semiconductor chip to be efficiently released by transferring to the side of a heat radiator.

### SUMMARY OF THE INVENTION

The present invention employs the following means to solve the aforementioned problems.

The first invention of the present invention is a power module substrate comprising an insulating substrate, a circuitry layer laminated on one side of the insulating substrate, a metal layer laminated on the other side of the insulating

The first invention of the present invention is a power module comprising an insulating substrate, a circuitry layer laminated on one side of the insulating substrate, a metal layer laminated on the other side of the insulating substrate, a semiconductor chip loaded onto the circuitry layer by means of solder, and a radiator joined to the metal layer; wherein, the circuitry layer and the metal layer are composed of copper of at least 99.999% purity, and wherein the average particle diameter of crystalline particles of circuitry layer and the metal layer from 1.0 mm to 30 mm.

According to this power module, since the circuitry layer and the metal layer are composed of copper of at least 99.999% purity, internal stress is dissipated by recrystallization in the case of subjecting to repeated heat cycle. Thus, since there is no accumulation of internal stress, life of the substrate toward heat cycle can be extended. In addition, since the circuitry layer and metal layer are composed of copper, the thermal conductivity can be improved. Thus, heat from a semiconductor chip can be efficiently released by transferring to the side of a heat radiator.

The second invention of the present invention is the power module according to the above first invention wherein the radiator is joined to the metal layer by at least one of solder, brazing, and a diffused bonding.

According to this power module substrate, since the circuitry layer and metal layer are composed of copper of at least 99.999% purity, internal stress is dissipated by recrystallization in the case of subjecting to repeated heat cycle. Thus, since there is no accumulation of internal stress, life of the substrate toward heat cycle can be extended. In addition, since the circuitry layer and metal layer are composed of copper, the thermal conductivity can be improved. Thus, heat from a semiconductor chip can be efficiently released by transferring to a circuitry layer composed of copper, insulating substrate and metal layer composed of copper.

The third invention of the present invention is the power module according to the above first or second invention wherein the insulating substrate is composed of AlN, Al₂O₃, Si₃N₄ or SiC.

According to this power module according to this invention, since the circuitry layer and metal layer are composed of copper of at least 99.999% purity, internal stress is dissipated by recrystallization in the case of subjecting to repeated heat cycle. Thus, since there is no accumulation of internal stress, life of the substrate toward heat cycle can be extended. In addition, since the circuitry layer and metal layer are composed of copper, the thermal conductivity can be improved. Thus, heat from a semiconductor chip can be efficiently released by transferring to a circuitry layer composed of copper, an insulating substrate composed of AlN, Al₂O₃, Si₃N₄ or SiC and a metal layer composed of copper.
The fourth invention of the present invention is the power module according to any of the above first, second, and third inventions wherein the circuitry layer and the metal layer release stress within 24 hours at 100°C.

According to this power module, the metal layer and the circuitry layer are resistant to work hardening, the formation of cracks in the solder is prevented, and the circuitry layer is prevented from separating from the insulating substrate.

The fifth embodiment of the present invention is the power module according to any of the above first, second, and third embodiments wherein elongation during rupture of the circuitry layer and the metal layer is from 20% to 30% within the range of -40°C to 150°C.

According to this power module, the metal layer and the circuitry layer are resistant to work hardening, the formation of cracks in the solder is prevented, and the circuitry layer is prevented from separating from the insulating substrate.

In other words, in the case elongation over a range of -40°C to 150°C is less than 20%, work hardening occurs easily in the circuitry layer and the metal layer, and there is the risk of cracks forming in the solder between the circuitry layer and the semiconductor chip. In addition, in the case elongation over a range of -40°C to 150°C is greater than 30%, excessive thermal stress occurs between the circuitry layer and the solder, cracks form in the solder between the circuitry layer and the semiconductor, and there is the risk of the circuitry layer separating from the insulating substrate.
The sixth invention of the present invention is the power module according to any of the above first, second, and third inventions wherein the thickness of the circuitry layer and the metal layer is from 0.04 mm to 1.0 mm.

According to this power module, the metal layer and the circuitry layer are resistant to work hardening, the formation of cracks in the solder is prevented, and the circuitry layer is prevented from separating from the insulating substrate.

Furthermore, in the case the thickness of the metal layer and the circuitry layer is less than 0.04 mm, the circuitry layer is unable to alleviate stress generated between the semiconductor chip and insulating substrate, and there is the risk of cracks forming in the solder. In addition, in the case the thickness if greater than 1.0 mm, the strength of the circuitry layer becomes excessively large, resulting in the risk of the insulating substrate being cracked by repeated heat cycle.

The seventh invention of the present invention is the power module described in any of the above first, second, and third inventions wherein the conductivity of the circuitry layer and the metal layer is at least 99% IACS. IACS refers to the International Annealed Copper Standard.

According to this power module, the circuitry layer is prevented from being separated from the insulating substrate.

According to the power module substrate of the invention, due to the distinct average particle diameter of crystalline particles of the circuitry layer and the metal layer, there is no occurrence of warping or other problems in the circuitry layer and the metal layer, and work hardening is prevented in the circuitry layer and the metal layer.

Furthermore, the average particle diameter described in this invention refers the average of the average crystalline particle diameter following production of the power module.

On the other hand, in the case the average particle diameter is less than 1.0 mm, work hardening occurs easily during heat cycle in the metal layer and the circuitry layer, and there is the risk of cracks forming in the solder between the circuitry layer and the semiconductor chip. In addition, if the average particle diameter exceeds 30 mm, anisotropy of mechanical strength occurs in the metal layer and the circuitry layer, resulting in the occurrence of warping and other problems.

Moreover, according to the power module substrate of the present invention, since a circuitry layer and a metal layer are composed of copper of at least 99.999% purity, internal stress is dissipated by recrystallization even when subjected to repeated heat cycle. Thus, since there is no accumulation of internal stress, life of the substrate toward heat cycle can be extended considerably. In addition, since the circuitry layer and metal layer are composed of copper having satisfactory thermal conductivity, heat from a semiconductor chip can be efficiently released by transferring to the side of a radiator. Thus, a power module substrate can be provided that satisfies both long life toward heat cycle and satisfactory thermal conductivity.

### BRIEF DESCRIPTION OF THE DRAWINGS

FIG. 1 is a schematic cross-sectional view showing one embodiment of a power module substrate according to the present invention.
FIG. 2 is a schematic cross-sectional view showing an example of a power module substrate of the prior art.
FIG. 3 is a schematic cross-sectional view showing another example of a power module substrate of the prior art.

### DESCRIPTION OF THE PREFERRED EMBODIMENTS

The following provides an explanation of an embodiment of the present invention with reference to the drawings.

FIG. 1 shows one embodiment of a power module according to the present invention. This power module 1 is provided with a insulating substrate (ceramic layer) 2, a circuitry layer 3 laminated on one side of insulating substrate 2, a metal layer 4 laminated on the other side of insulating substrate 2, a semiconductor chip 5 loaded on circuitry layer 3, and a radiator 6 joined to metal layer 4.

Insulating substrate 2 is formed to a desired size from, for example, AlN, Al₂O₃, Si₃N₄ or SiC, and circuitry layer 3 and metal layer 4 are laminated and adhered to its upper and lower surfaces, respectively.

Examples of methods for laminating and adhering circuitry layer 3 and metal layer 4 to insulating substrate 2 include the so-called Direct Bonding Copper (DBC) method in which a load of 0.5-2 kgf/cm² (4.9 x 10⁴ to 19.6 x 10⁴ Pa) is applied thereto followed by heating to 1065°C in an N₂ atmosphere, and an active metal method in which a load of 0.5-2 kgf/cm² (4.9 x 10⁴ to 19.6 x 10⁴ Pa) is applied thereto followed by heating to 800-900°C in a vacuum. These methods should be suitably selected and used according to the specific application.

Circuit layer 3 and metal layer 4 are composed of Cu (5N-Cu) of at least 99.999% purity. 5N-Cu has a recrystallization temperature from room temperature (RT) to 150°C. Thus, work hardening that occurs at high temperatures during heat cycle can be inhibited without the accumulation of internal stress even when subjected to repeated heat cycle of -40 to 125°C.

Circuit layer 3 and metal layer 4 may also be composed of Cu (6N-Cu) of at least 99.9999% purity. 6N-Cu has a recrystallization temperature from room temperature (RT) to 100°C. Thus, similar to 5N-Cu, work hardening that occurs at high temperatures during heat cycle can be inhibited without the accumulation of internal stress even when subjected to repeated heat cycle of -40 to 125°C, and the substrate which can stand toward more than 3000 cycles can be obtained similar to the case of composing the circuitry layer and metal layer with Al.

A circuit pattern for loading semiconductor chip 5 is formed in circuitry layer 3, and semiconductor chip 5 is loaded by means of solder 7 in the upper section of this circuitry layer 3. Radiator 6 is integrally joined to the lower surface of metal layer 4 by solder 8, brazing or a diffused bonding.

Radiator 6 couples a plurality of radiator bodies composed of a heat-conducting material such as Al or Cu (material having satisfactory thermal conductivity) and a low thermal expansion material like high carbon steel (Fe-C) to form a multilayer structure. It is used by attaching to a cooling sink 9 located below it, and heat from semiconductor chip 5 that is transferred to radiator 6 is discharged to the outside by means of cooling water (or cooling air) within cooling sink 9.

In this power module substrate 1 according to this embodiment composed in the manner described above, since circuitry layer 3 and metal layer 4 are composed of Cu (5N-Cu) of at least 99.999% purity, there is no accumulation of internal stress even when used under conditions of being repeatedly subjected to heat cycle of -40 to 125°C, and work hardening at high temperatures during heat cycle can be inhibited. Thus, this power module substrate can be used in devices that operate at high temperatures in the manner of SiC or GaN.

In addition, also in the case of composing circuitry layer 3 and metal layer 4 with Cu (6N-Cu) of at least 99.9999% purity, there is no accumulation of internal stress even when used under conditions of being repeatedly subjected to heat cycle of -40 to 125°C, and work hardening at high temperatures during heat cycle can be inhibited. Thus, this power module substrate can be used even in devices that operate at temperatures of 125°C and above (such as Si semiconductors).

Table 1 shows the results of comparing the lives toward heat cycle of power module substrates of the prior art and power module substrates of the present invention. Here, ceramics is used for the insulating substrate, the metal circuit indicates a circuitry layer and a metal layer, and OFC indicates oxygen-free copper (Cu: 99.9-99.99%). It can be understood from Table 1 that the power module substrates according to the present invention have a longer life than the power module substrates of the prior art.

**Table 1**

| | Ceramics | | | Metal Circuit | | | Temperature cycling life |
|---|---|---|---|---|---|---|---|
| | Dim. (mm) | Thick. (mm) | Material | Dim. (mm) | Thick. (mm) | Material | |
| Prior Art | 30x30 | 0.635 | AlN | 28x28 | 0.3 | OFC | 520 |
| | 40x50 | 0.635 | AlN | 38x48 | 0.4 | Al | 5200 |
| | 30x15 | 0.635 | AlN | 28x13 | 0.6 | Al | 3100 |
| | 50x50 | 0.635 | Al₂O₃ | 48x48 | 0.3 | OFC | 1320 |
| | 70x35 | 0.32 | Al₂O₃ | 68x33 | 03 | OFC | 510 |
| | 60x35 | 0.32 | Al₂O₃ | 58x33 | 0.4 | Al | 2900 |
| | 30x30 | 0.635 | Si₃N₄ | 28x28 | 03 | OFC | 2800 |
| | 30x20 | 0.32 | Si₃N₄ | 28x18 | 0.6 | Al | 3500 |
| | 50x40 | 0.32 | Si₃N₄ | 48x38 | 0.4 | Al | 3800 |
| Present Invention | 30x30 | 0.635 | AlN | 28x28 | 0.3 | 6N-Cu | 5200 |
| | 40x50 | 0.635 | AlN | 38x48 | 0.4 | 6N-Cu | 5210 |
| | 30x15 | 0.635 | AlN | 28x13 | 0.6 | 6N-Cu | 6200 |
| | 50x50 | 0.635 | Al₂O₃ | 48x48 | 0.3 | 6N-Cu | 5800 |
| | 70x35 | 0.32 | Al₂O₃ | 68x33 | 0.3 | 6N-Cu | 4800 |
| | 60x35 | 0.32 | Al₂O₃ | 58x33 | 0.4 | 6N-Cu | 3520 |
| | 30x30 | 0.635 | Si₃N₄ | 28x28 | 0.3 | 6N-Cu | 8250 |
| | 30x20 | 0.32 | Si₃N₄ | 28x18 | 0.6 | 6N-Cu | 5630 |
| | 50x40 | 0.32 | Si₃N₄ | 48x38 | 0.4 | 6N-Cu | 7520 |

The following provides an explanation of a second embodiment of the present invention. Since the constitution of the present embodiment is the same as the constitution shown in FIG. 1, an explanation is provided using different reference symbols.

Circuit layer 3a and metal layer 4a in the present embodiment are composed of Cu (5N-Cu) that releases stress at 100°C or lower. Here, the release of stress refers to the dissipation of point defects, the rearrangement of dislocation and so forth that occur within crystals prior to the occurrence of recrystallization.

Consequently, circuitry layer 3a and metal layer 4a are resistant to the accumulation of internal stress due to the ease of occurrence of the dissipation of defects, rearrangement of dislocation and so forth.

In other words, even if subjected to repeated heat cycle of -40 to 125°C, since dissipation of defects, rearrangement of dislocation and so forth occur at 100°C or lower, circuitry layer 3a and metal layer 4a return to a stress-free state and demonstrate little change in hardness as a result of being resistant to work hardening.

Thus, circuitry layer 3a is able to alleviate stress generated between semiconductor chip 5 and insulating substrate 2. In addition, it is also able to prevent the formation of cracks in solder 7.

Table 2 shows the relationship between changes in hardness following heat cycle (-40 to 125°C x 15 minutes, 3000 cycles) and the defect rate of insulating circuit substrates (defect: cracking of ceramic substrate or separation between Cu circuit and ceramic substrate). Samples were produced having different changes in hardness by changing the purity of the Cu (2N, 3N, 4N, 5N and 6N).

It can be understood from Table 2 that defects such as cracking of the ceramic substrate or separation between the Cu circuit and ceramic substrate occur in the case of a change in hardness of 30% or more.

**Table 2**

| Cu purity | Defect rate | Change in hardness |
|---|---|---|
| 2N | 100% | 42% |
| 3N | 83% | 39% |
| 4N | 26% | 30% |
| 5N | 0% | 24% |
| 6N | 0% | 22% |

In addition, in the following Table 3, it can be seen that in the case dissipation of dislocation occurs due to release of stress, defects such as cracking of insulating substrate 2 or separation between circuitry layer 3a and insulating substrate 2 do not occur.

The following provides an explanation of a third embodiment of the present invention. Since the constitution of this embodiment is the same as the constitution shown in FIG. 1, an explanation is provided using different reference symbols.

In the present embodiment, circuitry layer 3b and metal layer 4b are formed from Cu of at least 99.999% purity in which the range of elongation when ruptured over a range of -40°C to 150°C is from 20% to 30%. Here, since circuitry layer 3b and metal layer 4b are formed by the aforementioned copper, circuitry layer 3b and metal layer 4b are resistant to work hardening even when repeatedly subjected to heat cycle of -40 to 125°C.

Consequently, in the present embodiment as well, similar to the first embodiment, work hardening at high temperatures of heat cycle can be inhibited, enabling the power module substrate to be used in devices that operate at high temperatures in the manner of SiC and GaN.

Furthermore, it can be understood from the results of a tensile test at -40 to 150°C in Table 3 that, in the case of an elongation percentage of 20% to 30%, defects such as cracking of insulating substrate 2 or separation between circuitry layer 3a and insulating substrate 2 do not occur.

The following provides an explanation of a fourth embodiment of the present invention. Since the constitution of the present embodiment is the same as the constitution shown in FIG. 1, an explanation is provided using different reference symbols.

In the present embodiment, circuitry layer 3c and metal layer 4c are formed from pure copper of at least 99.999% purity, and the thickness of circuitry layer 3c and metal layer 4c is formed to be from 0.04 mm to 1.0 mm.

Since the thickness of circuitry layer 3c and metal layer 4c is formed to be from 0.04 mm to 1.0 mm, there is no accumulation of internal stress even when subjected to repeated heat cycle of -40 to 125°C, work hardening at high temperatures of heat cycle can be inhibited, and a life of 3000 cycles or more can be obtained. A particularly long life toward heat cycle can be obtained in the case insulating substrate 2 is formed from AlN or Al₂O₃.

The following provides an explanation of a fourth embodiment of the present invention. Since the constitution of the present embodiment is the same as the constitution shown in FIG. 1, an explanation is provided using different reference symbols. In the present embodiment, circuitry layer 3d and metal layer 4d are formed from pure copper of at least 99.999% purity and having a conductivity of at least 99% IACS.

It can be understood from Table 3 that in the case of N=5 or N=6 pure copper having conductivity of at least 99% IACS, defects such as cracking of the ceramic substrate or separation between the Cu circuit and ceramic substrate do not occur.

The following provides an explanation of a fifth embodiment of the present invention. Since the constitution of the present embodiment is the same as the constitution shown in FIG. 1, an explanation is provided using different reference symbols. In the present embodiment, circuitry layer 3e and metal layer 4e are formed from pure copper of at least 99.999% purity and having an average crystal particle diameter of 1.0 mm to 30 mm.

In the case of a crystal particle diameter of 1.0 mm to 30 mm, since circuitry layer 3e and metal layer 4e are both resistant to work hardening and resistant to the effects of solder 7 and 8, they are resistant to the occurrence of defects such as cracking of the ceramic substrate or separation between circuitry layer 3e and metal layer 4e.

Consequently, life of the substrate toward heat cycle of 3000 cycles of more can be obtained even when subjected to repeated heat cycle of -40 to 125°C.

Table 3 shows the results of measuring the defect rate, decrease in the number of dislocations, conductivity, average particle diameter and elongation percentage for the Cu circuit section cut out from each insulating substrate (residual ceramics were removed by etching with 20% NaOH).

Elongation percentage was determined using a thickness of the Cu circuit of 0.3 mm and a pulling speed of 0.5 mm/min. The number of dislocations was measured for the presence or absence of a decrease in the number of dislocations following heat treatment at 100°C. Measurement was performed by TEM observation of portions of the Cu material of an insulating circuit substrate, measuring the number of dislocations for N = 3, determining the average number of dislocations, and then determining whether the measured average number of dislocations decreased following heat treatment of the insulating circuit substrate for 3 hours at 100°C with respect to that before heat treatment. Conductivity was expressed as a ratio with the electrical conductivity of the International Annealed Copper Standard (IACS). Average crystal particle diameter was obtained by averaging the crystal particle diameter following heat treatment at 100°C.

Defect rate was determined by judging whether or not defects such as cracking of the ceramic substrate or separation between the Cu circuit and ceramic substrate occur for each of the test parameters.

As a result, defects such as cracking of the ceramic substrate or separation between the Cu circuit and ceramic substrate were determined not to occur in the case of an elongation percentage of 20% to 30% for N=5 or N=6 pure copper.

In addition, defects such as cracking of the ceramic substrate or separation between the Cu circuit and ceramic substrate were determined not to occur in the case of an average crystal particle diameter of 1.0 mm or more for N=5 or N=6 pure copper.

Moreover, defects such as cracking of the ceramic substrate or separation between the Cu circuit and ceramic substrate were determined not to occur in the case of conductivity being 99% IACS for N=5 or N=6 pure copper.

Moreover, defects such as cracking of the ceramic substrate or separation between the Cu circuit and ceramic substrate were determined not to occur in N=5 or N=6 pure copper in which a decrease in the number of dislocations occurs following heat treatment for 3 hours at 100°C.

**Table 3**

| Cu purity | Defect rate | Decrease in no. of dislocations | Conductivity (20°C) | Average crystal particle diameter | Elongation percentage | | | |
|---|---|---|---|---|---|---|---|---|
| | | | | | -40°C | RT | 80°C | 150°C |
| 2N | 100% | | 95 | 0.1 mm | 13% | 12% | 11% | 12% |
| 3N | 83% | | 96 | 0.2 mm | 16% | 15% | 15% | 13% |
| 4N | 26% | | 98 | 0.5 mm | 17% | 15% | 13% | 12% |
| 5N | 0% | Present | 99 | 1.9 mm | 22% | 21% | 23% | 22% |
| 6N | 0% | Present | 99 | 3.8 mm | 28% | 22% | 22% | 23% |

Table 4 describes the results of performing tensile tests on a pure copper A (N=5, vacuum-annealed material, thickness: 0.3 mm), pure copper B (N=3, vacuum-annealed material, thickness: 0.3 mm) and aluminum (vacuum-annealed material, thickness: 0.4 mm).

As a result, the elongation of pure copper A at -40 to 150°C was determined to be from 20% to 30%.

**Table 4**

| | | | | | | | | | | |
|---|---|---|---|---|---|---|---|---|---|---|
| | Samples: | | | | | | | | | |
| | (1) Pure copper A: Vacuum-annealed, thickness: 0.3 | | | | | | | | | |
| | (2) Pure copper B: Vacuum-annealed, thickness: 0.3 | | | | | | | | | |
| | (3) Aluminum: Vacuum-annealed, thickness: 0.4 | | | | | | | | | |

| | Mark | Cross-sectional area (mm²) | Yield strength | | Actual load (N) | Tensile load (N/mm²) | Elongation GL=50 | | Cutting location | Test temp. (°C) |
|---|---|---|---|---|---|---|---|---|---|---|
| | | | Load (N) | Stress (N/mm²) | | | Actual (mm) | (%) | | |
| A | A-1 | 3.85 | 180 | 47 | 529 | 137 | 13.7 | 27 | B | -40 |
| | A-2 | 3.85 | 164 | 43 | 583 | 151 | 14.8 | 30 | B | -40 |
| | A-3 | 3.85 | 149 | 39 | 458 | 119 | 10.7 | 21 | A | RT |
| | A-4 | 3.85 | 167 | 43 | 457 | 119 | 11.0 | 22 | B | RT |
| | A-5 | 3.85 | 134 | 35 | 480 | 125 | 12.0 | 24 | B | 80 |
| | A-6 | 3.85 | 185 | 48 | 427 | 111 | 9.1 | 18 | C | 80 |
| | A-7 | 3.85 | 155 | 40 | 409 | 106 | 9.0 | 18 | C | 150 |
| | A-8 | 3.85 | 159 | 41 | 375 | 97 | 10.8 | 22 | C | 150 |
| B | B-1 | 3.93 | 184 | 47 | 698 | 178 | 8.8 | 18 | C | -40 |
| | B-2 | 3.93 | 199 | 51 | 671 | 171 | 8.2 | 16 | C | -40 |
| | B-3 | 3.93 | 169 | 43 | 584 | 149 | 7.4 | 15 | C | RT |
| | B-4 | 3.93 | 179 | 46 | 579 | 147 | 7.2 | 14 | C | RT |
| | B-5 | 3.93 | 161 | 41 | 519 | 132 | 6.7 | 13 | C | 80 |
| | B-6 | 3.93 | 177 | 45 | 517 | 132 | 6.4 | 13 | C | 80 |
| | C-7 | 3.93 | 167 | 42 | 454 | 116 | 5.9 | 12 | C | 150 |
| | B-8 | 3.93 | 160 | 41 | 454 | 116 | 5.8 | 12 | C | 150 |
| C | C-1 | 5.08 | 123 | 24 | 199 | 39 | 16.0 | 32 | B | -40 |
| | C-2 | 5.08 | 118 | 23 | 188 | 37 | 12.2 | 24 | C | -40 |
| | C-3 | 5.08 | 120 | 24 | 158 | 31 | 10.4 | 21 | C | RT |
| | C-4 | 5.08 | 89 | 18 | 174 | 34 | 7.8 | 16 | C | RT |
| | C-5 | 5.08 | 103 | 20 | 117 | 23 | 13.4 | 27 | B | 80 |
| | C-6 | 5.08 | 83 | 16 | 130 | 26 | 14.1 | 28 | B | 80 |
| | C-7 | 5.08 | 72 | 14 | 88 | 17 | 12.5 | 25 | A | 150 |
| | C-8 | 5.08 | 73 | 14 | 108 | 21 | 17.0 | 34 | C | 150 |

| | | | | | | | | | | |
|---|---|---|---|---|---|---|---|---|---|---|
| Test piece: 12.5 (W) x 50 GL Strain gauge: KFH-5-120-C1-16 BIM3 for Cu, affixed to both sides KFH-5-120-C1-23 BIM3 for Al, affixed to both Sides Adhesive: EP-34B Cross head speed: 0.5 mm/min until yield strength, 5 mm/min after yield strength | | | | | | | | | | |

According to the power module substrate of the present invention, since a circuitry layer and a metal layer are composed of copper of at least 99.999% purity, internal stress is dissipated by recrystallization even when subjected to repeated heat cycle. Thus, since there is no accumulation of internal stress, life of the substrate toward heat cycle can be significantly extended. In addition, since the circuitry layer and metal layer are composed of copper having satisfactory thermal conductivity, heat from a semiconductor chip can be efficiently released by transferring to the side of a heat radiator. Thus, the potential for industrial utilization is recognized since a power module substrate can be provided that satisfies both long life with respect to heat cycle and satisfactory thermal conductivity.

## Claims

1. A power module (1) comprising:
an insulating substrate (2), a circuitry layer (3) laminated on one side of said insulating substrate, a metal layer (4) laminated on the other side of said insulating substrate, a semiconductor chip (5) loaded onto the circuitry layer by means of solder (7), and a radiator (6) joined to the metal layer;
wherein, the circuitry layer and the metal layer are composed of copper **characterised in that** said copper is of at least 99.999 % purity, and **in that**
the average particle diameter of crystalline particles of the circuitry layer and the metal layer is from 1.0 mm to 30 mm.

## Patentansprüche

1. Ein Leistungsmodul (1), umfassend:
ein isolierendes Substrat (2), eine Schaltungsschicht (3), die auf eine Seite des isolierenden Substrats auflaminiert ist, eine Metallschicht (4), die auf der anderen Seite des isolierenden Substrats auflaminiert ist, einen Halbleiterchip (5), der mittels Lot (7) auf der Schaltungsschicht aufgesetzt ist, und einen Kühler (6), der mit der Metallschicht verbunden ist;
wobei die Schaltungsschicht und die Metallschicht aus Kupfer sind,
**dadurch gekennzeichnet, dass** das Kupfer mindestens eine Reinheit von 99,999% aufweist und dass der durchschnittliche Partikeldurchmesser der kristallinen Partikel der Schaltungsschicht und der Metallschicht 1,0 mm bis 30 mm beträgt.

## Revendications

1. Module de puissance (1)
comprenant :
un substrat isolant (2), une couche de circuits (3) stratifiée sur un côté dudit substrat isolant, une couche métallique (4) stratifiée sur l'autre côté dudit substrat isolant, une puce semi-conductrice (5) chargée sur la couche de circuits au moyen d'une brasure tendre (7), et un radiateur (6) relié à la couche métallique ;
dans lequel, la couche de circuits et la couche métallique sont composées de cuivre **caractérisé en ce que** ledit cuivre est d'au moins 99,999% de pureté, et
**en ce que** le diamètre de particules moyen des particules cristallines de la couche de circuits et de la couche métallique est compris entre 1,0 mm et 30 mm.
